# EUROPÄISCHE PATENTSCHRIFT

(11) **EP 1 770 797 B1**
(45) Veröffentlichungstag und Bekanntmachung des Hinweises auf die Patenterteilung: **21.11.2012**
(21) Anmeldenummer: 06019934.6
(22) Anmeldetag: 22.09.2006
(51) Int. Cl.: B22F 7/06, B22F 3/22, H01L 33/00

(54) **Verfahren zur Herstellung eines strahlungsemittierenden Bauelements und strahlungsemittierendes Bauelement**
Method for producing a radiation emitting device and radiation emitting device
Procédé de production d'un élément émetteur de rayonnement et élément émetteur de rayonnement

(30) Priorität: 13.07.2006 DE 102006032415; 30.09.2005 DE 102005047167
(43) Veröffentlichungstag der Anmeldung: 04.04.2007
(73) Patentinhaber: OSRAM Opto Semiconductors GmbH, 93055 Regensburg (DE)
(72) Erfinder: Winter Matthias, 93059 Regensburg (DE); Jäger Harald, 93049 Regensburg (DE)
(74) Vertreter: Epping - Hermann - Fischer

(56) Entgegenhaltungen:
- DE-A1- 10 229 067
- US-A- 5 689 796
- US-A- 5 963 773
- US-A1- 2003 039 571

## Beschreibung

Die Erfindung betrifft ein Verfahren zur Herstellung eines strahlungsemittierenden Bauelements, das einen Gehäusekörper und einen Träger aufweist.

Im Besonderen handelt es sich bei dem Verfahren um ein MIM-(MIM: metal injection molding)-Fertigungsverfahren oder Pulvermetallspritzgussverfahren, das insbesondere zur Herstellung kleiner, komplexer Bauteile geeignet ist.

Diese Patentanmeldung beansprucht die Priorität der deutschen Patentanmeldung 102005047167.6 und die Priorität der deutschen Patentanmeldung 102006032415.3.

Bei herkömmlichen oberflächenmontierbaren optoelektronischen Bauteilen wird ein vorgehäustes Bauteil dadurch hergestellt, dass ein vorgefertigter Leiterrahmen (Leadframe) mit einem geeigneten Kunststoffmaterial umspritzt wird, welches das Gehäuse des Bauteils bildet. Dieses Bauteil weist z.B. an der Oberseite eine Vertiefung bzw. Ausnehmung auf, in die von zwei gegenüberliegenden Seiten Leadframe-Anschlüsse eingeführt sind, auf dessen einem ein Halbleiterchip, wie beispielsweise ein LED-Chip, aufgeklebt und elektrisch kontaktiert ist. In diese Ausnehmung wird dann eine in der Regel transparente Vergussmasse eingefüllt. Diese Grundform von oberflächenmontierbaren optoelektronischen Bauteilen ist beispielsweise aus dem Artikel "Siemens SMT-Topled für die Oberflächenmontage" von F. Möllmer und G. Waitl, Siemens Components 29 (1991), Heft 4, Seiten 147 bis 149, bekannt.

Die Druckschrift US 2003/0039571 A1 beschreibt beispielsweise die Herstellung eines Gehäuses für ein Halbleiterbauelement.

Die Druckschrift DE 102 29 067 A1 offenbart ebenfalls ein Gehäuse für ein Halbleiterbauelement.

Es ist Aufgabe der vorliegenden Erfindung, ein Verfahren anzugeben, das sich für die vereinfachte Herstellung eines Bauelements mit einem Träger und einem Gehäusekörper eignet. Ferner ist es Aufgabe der vorliegenden Erfindung, ein strahlungsemittierendes Bauelement anzugeben, das einen Träger und einen Gehäusekörper aufweist, der sich möglichst einfach herstellen lässt.

Diese Aufgaben werden durch ein Verfahren mit den Merkmalen des Patentanspruchs 1 und einen Träger mit den Merkmalen des Patentanspruchs 9 gelöst. Vorteilhafte Ausgestaltungen sind Gegenstand der abhängigen Ansprüche.

Bei dem erfindungsgemäßen Verfahren gemäβ Anspruch 1 zur Herstellung eines strahlungsemittierenden Bauelements, das einen Gehäusekörper und einen Träger aufweist, wird der Träger in einem Spritzgussverfahren aus einer Formmasse, die ein Metall enthält, hergestellt.

Bei einem erfindungsgemäßen strahlungsemittierenden Bauelement gemäβ Anspruch 9, das einen Gehäusekörper und einen Träger aufweist, enthält der Träger ein spritzgegossenes Metall.

Ein erfindungsgemäßer Träger für ein strahlungsemittierendes Bauelement wird bevorzugt mittels eines Pulverspritzgussverfahrens hergestellt, wobei zur Herstellung des Trägers vorzugsweise ein Pulver, das Metall enthält, verwendet wird. Durch dieses Verfahren kann der Träger und ferner das Bauelement auf einfache Weise als Einzelteil hergestellt werden. Im Vergleich zur Leadframe-Technologie, wobei die Bauelemente durch Trennprozesse wie beispielsweise Stanzen, Sägen oder Lasertrennen vereinzelt werden müssen, entfällt hier dass stressbelastende Vereinzelungsverfahren.

Beim Pulverspritzgussverfahren auf der Basis von Metall wird zunächst ein feines Pulver oder eine Paste, die Metall enthält, mit einem Binder gemischt und granuliert. Die so entstandene Formmasse wird als Feedstock bezeichnet. Vorzugsweise enthält der Binder ein Material aus einer organischen Verbindung, besonders bevorzugt aus einem Polymer, zum Beispiel Polyoxymethylen, so dass bei einer Erwärmung beziehungsweise Verdichtung der Formmasse ein für das Pulverspritzgussverfahren geeignetes, fließfähiges Compound entsteht. Ferner wird der Formmasse ein Formbinder beigefügt, der vorzugsweise ein Material aus einer anorganischen Verbindung enthält.

Die Formmasse kann in eine Spritzgussmaschine eingebracht und dort zunächst aufgeschmolzen werden. Die Formmasse wird in eine Spritzgussform eingefüllt und zu einem Träger-Formteil (so genannter "Grünling") gespritzt. Das Träger-Formteil kann entformt werden, sobald die Formmasse auf ausreichende Entformfestigkeit abgekühlt ist.

Anschließend wird der Binder aus dem Träger-Formteil entfernt. Vorzugsweise geschieht dies durch thermische Verflüchtigung und/oder Lösungsmittel und/oder Katalysation und/oder Pyrolyse. Das binderlose Träger-Formteil (so genannter "Bräunling") weist hauptsächlich Pulverpartikel auf. Dabei sorgt der Formbinder, der besonders bevorzugt nicht ausgetrieben wird, für die notwendige Festigkeit des Träger-Formteils bei der weiteren Handhabung.

Abschließend wird das Träger-Formteil zum fertigen Träger gesintert. Beim Sintern wird zunächst der Formbinder ausgetrieben. Erst wenn keine Formbinderreste mehr im Träger-Formteil vorhanden sind, wird die Temperatur auf Sintertemperatur erhöht. Das Träger-Formteil besteht zu diesem Zeitpunkt nur noch aus einem labilen Pulvergerüst. Beim Erreichen der Sintertemperatur beginnen sich die Hohlräume zwischen den Pulverpartikeln mit Materie auszufüllen.

Das Träger-Formteil kann teilweise stark schwinden bis es seine endgültige Träger-Form erreicht hat. Je nach Binder - und Formbindergehalt der Formmasse kann der Schwund zwischen 15% und 20% betragen.

Das Sintern wird vorzugsweise im Vakuum oder mit einer Schutzgasatmosphäre durchgeführt. Die Schutzgasatmosphäre beziehungsweise das Vakuum sind notwendig, um unerwünschte chemische Reaktionen zu verhindern. Als Schutzgase sind kostengünstige Gase wie beispielsweise H₂ und CO geeignet.

Außerdem wird für das Pulvermetallspritzgussverfahren vorzugsweise ein Material verwendet, das ein leicht veredelbares Metall enthält. Denkbar ist sowohl ein Material, das ein elementares Metall enthält, als auch ein Material, das eine Legierung enthält. Besonders bevorzugt wird Wolfram oder eine Wolframlegierung verwendet.

Die Sintertemperatur richtet sich nach dem verwendeten Material und beträgt beispielsweise für ein Wolfram enthaltendes Material zwischen 1000° und 3000°C. Vorteilhafterweise muss bei diesem Verfahren mit der Entnahme nicht gewartet werden, bis der Träger auf Raumtemperatur abgekühlt ist. Der Träger kann schon nach einer kurzen Abkühlzeit entnommen werden, wodurch sich das Herstellungsverfahren verkürzen lässt.

Der spritzgegossene Träger für einen strahlungsemittierenden Halbleiterkörper wird in einem Gehäusekörper eingebettet. Dies geschieht durch eine vorteilhafte Verknüpfung der Herstellung des Trägers mit der Herstellung des Gehäusekörpers. Besonders vorteilhaft kann die Herstellung des Trägers mit der Herstellung des Gehäusekörpers durch ein Spritzgussverfahren verknüpft werden. Insbesondere ist dieses Spritzgussverfahren ein Pulverspritzgussverfahren.

Das Pulverspritzgussverfahren für den Gehäusekörper weist dem Pulverspritzgussverfahren für den Träger entsprechende Schritte auf.

In einem ersten Schritt wird eine Formmasse für den Gehäusekörper erstellt, die ein Pulver oder eine Paste, einen Binder, einen oder mehrere Hilfsstoffe und einen Formbinder enthält. Das Pulver oder die Paste kann beispielsweise ein Kunststoffpulver oder eine Kunststoffpaste sein.

In einem zweiten Schritt wird in einer Spritzgussmaschine die vornehmlich erwärmte, fließfähige Formmasse in eine Spritzgussform eingefüllt und zu einem Gehäusekörper-Formteil geformt. In einem weiteren Schritt wird aus dem Formteil der Binder entfernt, vorzugsweise durch Erwärmung und/oder Lösungsmittel und/oder Katalysation und/oder Pyrolyse. Ferner wird das Formteil gesintert und dabei der Formbinder entfernt. Die Sintertemperatur richtet sich nach dem für den Gehäusekörper verwendeten Material. Bei einem Keramikmaterial sind Temperaturen zwischen 300°C und 2000°C möglich.

Einzelne Schritte zur Herstellung des Trägers und zur Herstellung des Gehäusekörpers können nacheinander oder parallel ausgeführt werden.

Bei einer ersten Variante des Herstellungsverfahrens für ein strahlungsemittierendes Bauelement werden zwei separate Verfahren durchgeführt. Mittels des Pulvermetallspritzgussverfahrens wird der Träger hergestellt. Ferner wird der Gehäusekörper vorzugsweise mittels des Pulverspritzgussverfahrens angefertigt. Die beiden separaten Teile werden anschließend miteinander verbunden. Dies kann geschehen, indem der Gehäusekörper auf den Träger montiert wird. Für die Montage kann er beispielsweise Montagezapfen aufweisen, die in Vertiefungen des Trägers passen.

Bei einer zweiten Variante des Herstellungsverfahrens für ein strahlungsemittierendes Bauelement wird zunächst der Träger mittels des Pulvermetallspritzgussverfahrens hergestellt, wobei alle Verfahrensschritte durchlaufen werden. Anschließend wird der fertige Träger in eine Spritzgussform eingelegt, wo er mit einem Material umspritzt wird, das den Gehäusekörper bildet. Das Umspritzen geschieht gemäß den Verfahrensschritten, die bezüglich des Pulverspritzgussverfahrens für einen Gehäusekörper beschrieben sind. Vorteilhafterweise ist hierbei beim Sintern des Gehäusekörpers ein Schwund zu erwarten. Dadurch schrumpft der Gehäusekörper auf den Träger auf, wodurch die Haftung zwischen dem Gehäusekörper und dem Träger verbessert wird.

Bei einer dritten Variante des Herstellungsverfahrens für ein strahlungsemittierendes Bauelement wird das Träger-Formteil in eine Spritzgussform eingebracht und mit der Formmasse des Gehäusekörpers umspritzt. Anschließend wird der Binder nach einer der bereits genannten Methoden entfernt. Das Träger-Formteil und das Gehäusekörper-Formteil werden gemeinsam gesintert und nach einer kurzen Abkühlzeit entformt. Es liegt dann ein strahlungsemittierendes Bauelement vor, das einen spritzgegossenen Träger und Gehäusekörper aufweist. Vorteilhafterweise wird bei diesem Verfahren lediglich eine Spritzgussmaschine verwendet und ein Zweikomponenten (2K)-Pulverspritzguss durchgeführt. Dadurch kann eine einfache und kostenersparende Herstellung eines strahlungsemittierenden Bauelements realisiert werden.

Obwohl zur Herstellung eines strahlungsemittierenden Bauelements, das einen Träger und einen Gehäusekörper aufweist, wobei beide Teile in einem Spritzgussverfahren gefertigt werden, zwei verschiedene Spritzgussformen nötig sind, bedarf es also nicht notwendigerweise zweier Spritzgussmaschinen. Vielmehr können die beiden Spritzgussverfahren in einer gemeinsamen Spritzgussmaschine erfolgen, wobei zum Beispiel ein Schieberwerkzeug eingesetzt wird oder beispielsweise mittels eines Drehtellers oder einer Aufspannplatte, mittels eines Handlingsgeräts oder Würfelwerkzeugs in eine andere Spritzgussform (so genanntes "Formnest") umgelegt wird. Unter einer Spritzgussform wird in diesem Zusammenhang ein formgebender Bereich bzw. eine Form verstanden, die der Formmasse ihre Gestalt verleiht.

Vorteilhafterweise können mittels des Spritzgussverfahrens komplexe Geometrien realisiert werden. Beispielsweise können bei der Formgebung Vertiefungen im Träger zur Verankerung des Gehäusekörpers berücksichtigt werden. Bei gestanzten Leiterrahmen müssen derartige Vertiefungen in einem zusätzlichen Schritt gestanzt werden.

Ferner sind durch das Spritzgussverfahren präzise Abmessungen des Trägers und des Gehäusekörpers mit Toleranzen von ± 0,5 % vom Nennmaß möglich.

Zweckmäßigerweise wird auf den Träger eine Metallisierung, beispielsweise mittels eines Galvanikverfahrens, aufgebracht, damit der strahlungsemittierende Halbleiterkörper, der auf den Träger montiert wird, elektrisch anschließbar ist. Vorzugsweise erfolgt vor der Aufbringung der Metallisierung eine Reinigung des Trägers von Rückständen aus den beiden Spritzgussverfahren, beispielsweise mittels einer Plasmareinigung oder einer nasschemischen Reinigung.

Für die vereinfachte Aufbringung der Metallisierung auf den Träger mittels eines Galvanikverfahrens kann eine Nutzenfertigung der Bauelemente vorteilhaft sein. Allerdings müssen die Bauelemente dann vereinzelt werden, was zu Stressbelastungen beim Trennen der Bauelemente führen kann.

Für ein strahlungsemittierendes Bauelement, das alterungs - und zyklusbeständig sein sollte, sind UV-Stabilität und Hochtemperaturbeständigkeit wichtige Kriterien.
Ferner kann ein spritzgegossenes Kunststoffmaterial zur Herstellung des Gehäusekörpers vorteilhafte Verwendung finden.

Ein Vorteil eines pulverspritzgegossenen Gehäusekörpers ist dessen raue Oberfläche, die das Aufbringen von Materialien, beispielsweise Vergussmaterialien, erleichtert.

Ferner kann die Formmasse, woraus der Gehäusekörper hergestellt ist, eine geeignete Mischung von Materialien enthalten, wodurch beispielsweise eine verbesserte Haftung zu Vergussmaterialien erzielt werden kann, mit denen die Ausnehmung gefüllt ist, in der sich vorzugsweise der strahlungsemittierende Halbleiterkörper befindet. Zum Schutz des Halbleiterkörpers vor äußeren, schädigenden Einwirkungen kann die Ausnehmung zumindest teilweise gefüllt sein. Die Haftung ist durch die Zusammensetzung der für den Gehäusekörper verwendeten Materialien einstellbar.

Für eine weiter verbesserte Haftung können spezielle Verankerungen für einen Verguss, beispielsweise Hinterschnitte, realisiert sein. Insbesondere kann der Gehäusekörper einen Überlaufrahmen aufweisen, in welchen überschüssiges Vergussmaterial aus der Ausnehmung entweichen kann, wobei das überschüssige Vergussmaterial die gefüllte Ausnehmung vorzugsweise überdeckt und eine verbesserte Haftung bewirkt.

Als Vergussmaterialien eignen sich vorteilhafterweise strahlungsdurchlässige, insebesondere transparente Materialien. Reaktionsharze wie beispielsweise Epoxidharze, Acrylharze, Silikonharze und Polyurethanharze oder eine Mischung dieser Harze finden bevorzugt Verwendung. Ein Silikonharz stellt sich im Bezug auf Zyklenbeständigkeit, Alterungsstabilität und Strahlungsbeständigkeit, insbesondere im blauen und ultravioletten Spektralbereich, als vorteilhaft heraus.

Ferner können sich Hybridmaterialien wie z.B. Mischungen aus Epoxidharzen und Silikonharzen besonders eignen, da sie gegenüber Silikonharzen die Vorteile kürzerer Aushärtezeiten, besserer Entformbarkeit und besserer Hafteigenschaften gegenüber dem Trägermaterial aufweisen. Gegenüber Epoxidharzen haben Hybridmaterialien den Vorteil gesteigerter UV-Stabilität.

Eine verbesserte Haftung ist ferner für eine aufgebrachte Metallisierungsschicht gewünscht. Die Metallisierungsschicht ist vorzugsweise auf Innenwänden des Gehäusekörpers aufgebracht, die die Ausnehmung begrenzen. Sie kann als Reflektor für die Strahlung des Halbleiterkörpers in der Ausnehmung dienen, wodurch sich die Lichtauskopplung aus dem Bauelement steigern lässt. Alternativ kann der Gehäusekörper Partikel mit reflektierender Wirkung, beispielsweise TiO₂ enthalten, wodurch sich der Reflexionsgrad steigern lässt. Diese Realisierungsmöglichkeit eines optischen Reflektors stellt eine vorteilhafte Alternative dar, da sie einfach realisierbar ist und außerdem ein Herstellungsschritt, die Innenwandmetallisierung, entfällt.

Günstigerweise kann durch den Reflektor die Abstrahlcharakteristik und die Intensität der vom Bauelement emittierten Strahlung positiv beeinflusst und damit die Leistung des strahlungsemittierenden Bauelements verbessert werden.

Die Ausnehmung kann sich beispielsweise ausgehend von einer dem Träger gegenüberliegenden Oberseite des Gehäusekörpers bis hin zum Träger verjüngen und trichterförmig ausgestaltet sein. Eine Umhüllung in der Ausnehmung kann außer dem Vergussmaterial ein Konversionsmaterial enthalten, wodurch sich die vom Halbleiterkörper emittierte Strahlung teilweise in Strahlung einer größeren Wellenlänge umwandeln lässt. Durch die Mischung von Strahlung mit unterschiedlicher Wellenlänge kann beispielsweise "weißes" Licht erzeugt werden.

Bei einem strahlungsemittierenden Bauelement kann im Betrieb Verlustwärme entstehen, was sich nachteilig auf eine dauerhafte Funktionsfähigkeit auswirken kann. Vorzugsweise weist daher eine Auflagefläche des strahlungsemittierenden Bauelements thermische Anschlussbereiche auf. Besonders vorteilhafterweise weist der Gehäusekörper auf der der Auflagefläche zugewandten Seite eine Ausnehmung für ein Kühlelement auf. Weiter bevorzugt ist auch das Kühlelement aus einem spritzgegossenen Material gebildet, das ein Metall oder ein Keramikmaterial enthalten kann.

Weitere Merkmale, Vorteile und Weiterbildungen eines strahlungsemittierenden Bauelements ergeben sich aus den nachfolgend in Verbindung mit den Figuren 1 bis 6 erläuterten Ausführungsbeispielen. Gleiche oder gleich wirkende Bestandteile sind mit den gleichen Bezugszeichen versehen.

Es zeigen:
- Figuren 1a bis 1e: eine schematische Darstellung eines Ausführungsbeispiels eines erfindungsgemäßen Verfahrens anhand von fünf Herstellungsschritten,
- Figur 2: eine schematische Schnittansicht eines ersten Ausführungsbeispiels eines strahlungsemittierenden Bauelements,
- Figur 3: eine schematische Schnittansicht eines zweiten Ausführungsbeispiels eines strahlungsemittierenden Bauelements,
- Figuren 4a, 4b, 4c: drei verschiedene schematische Ansichten eines dritten Ausführungsbeispiels eines strahlungsemittierenden Bauelements,
- Figuren 5a, 5b, 5c: drei verschiedene schematische Ansichten eines vierten Ausführungsbeispiels eines strahlungsemittierenden Bauelements,
- Figur 6: eine schematische Aufsicht einer möglichen Anordnung von mehreren strahlungsemittierenden Halbleiterkörpern.

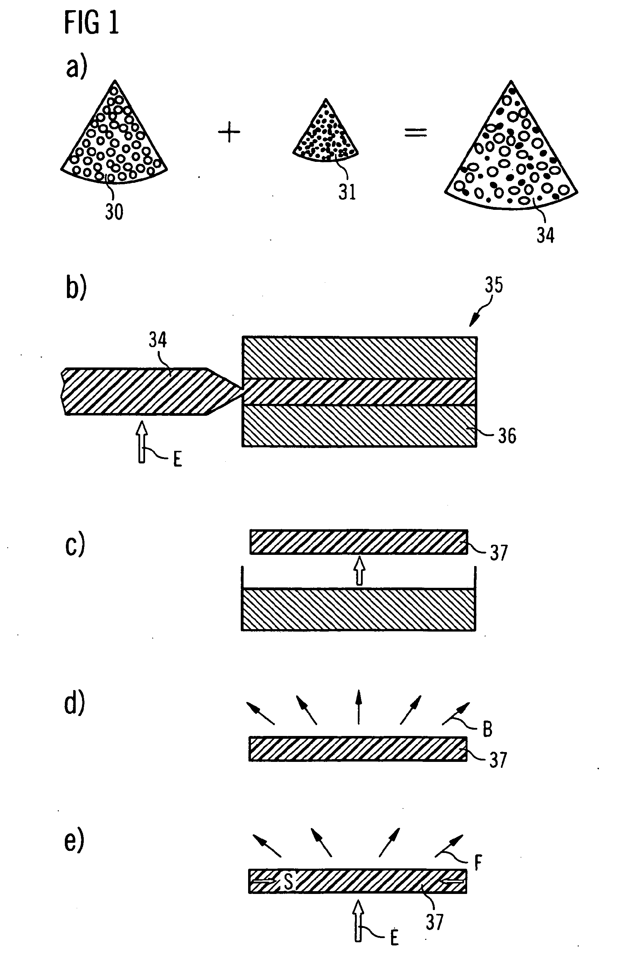

Die Figuren 1a bis 1e zeigen ein Ausführungsbeispiel eines Pulverspritzgussverfahrens auf der Basis von Metall zur Herstellung eines Trägers für ein strahlungsemittierendes Bauelement.

Figur 1a zeigt einen ersten Schritt, bei dem ein feines Pulver 30, das ein Metall, vorzugsweise Wolfram oder eine Wolfram-Legierung, enthält, mit Zusätzen 31, einem Binder, einem Formbinder und Hilfsstoffen, gemischt und zu einer Formmasse 34 granuliert wird. Der durchschnittliche Durchmesser eines Partikels liegt dabei zwischen 5 und 10 µm.

Besonders bevorzugt enthält der Binder ein Material aus einer organischen Verbindung, beispielsweise ein Polymer, das die plastische Formbarkeit der Formmasse bei Erwärmung oder Verdichtung erhöht. Der Formbinder enthält ein organisches Material.

Die Formmasse 34 wird, wie in Figur 1b dargestellt, in eine Spritzgussmaschine 35 eingebracht und erwärmt (Pfeil E), so dass ein fließfähiges Compound entsteht, das in eine Spritzgussform 36 eingefüllt wird. In der Spritzgussform 36 kühlt die Formmasse bis zu einer Temperatur ab, bei der sie eine ausreichende Entformfestigkeit erreicht hat.

Bei ausreichender Entformfestigkeit wird ein so gebildetes Träger-Formteil 37 entformt (s. Figur 1c).

Anschließend wird der Binder aus dem Träger-Formteil 37 entfernt, wie dies in Figur 1d durch Pfeile B angedeutet ist. Das anzuwendende Entbinderungsverfahren hängt vom Bindersystem ab. Das am weitesten verbreitete Verfahren ist das katalytische Entbindern, weil es die kürzesten Entbinderungszeiten gewährleistet. Die Entbinderungszeiten liegen zwischen einigen Stunden und mehreren Tagen. Dies hängt vom Bindersystem und der Wanddicke des Träger-Formteils ab.

In Figur 1e ist ein abschließender Schritt, das Sintern, dargestellt. Hierbei wird zunächst durch Wärmezufuhr (Pfeil E) aus dem binderlosen Träger-Formteil 37, das hauptsächlich aus Pulverpartikeln besteht und im Wesentlichen durch den Formbinder stabilisiert wird, der Formbinder entfernt (Pfeile F). Dann wird die Temperatur auf Sintertemperatur erhöht, die beispielsweise für ein Wolfram enthaltendes Material zwischen 1000°C und 3000°C liegen kann, und das Träger-Formteil zum fertigen Träger gesintert. Dabei ist mit einem Schrumpf zu rechnen (Pfeile S). Der Träger kann schon nach einer kurzen Abkühlzeit entnommen werden.

Zur Herstellung eines erfindungsgemäßen strahlungsemittierenden Bauelements wird der Träger mit einem Gehäusekörper versehen.

Beispielsweise kann ein separat gefertigter Gehäusekörper auf den spritzgegossenen Träger montiert werden.

Alternativ kann der fertige Träger mit einem Material für den Gehäusekörper umspritzt werden, wobei der Träger in eine Spritzgussform eingelegt und in eine Formmasse für den Gehäusekörper eingebettet wird. Die in den Figuren 1a bis 1e beschriebenen Verfahrensschritte werden in analoger Weise zur Herstellung des Gehäusekörpers durchlaufen.

Eine weitere Möglichkeit zur Herstellung eines erfindungsgemäßen Bauelements besteht in einem 2K-Spritzguss. Hierbei können die Schritte des Erstellens und Erwärmens beziehungsweise Verdichtens der Formmasse für den Träger und den Gehäusekörper parallel in einer gemeinsamen Spritzgussmaschine durchgeführt werden. Durch eine geeignete Unterteilung einer Spritzgussform können darin sowohl das Träger-Formteil als auch das Gehäusekörper-Formteil gebildet werden. Anschließend werden die beiden Formteile gemeinsam entbindert und gesintert.

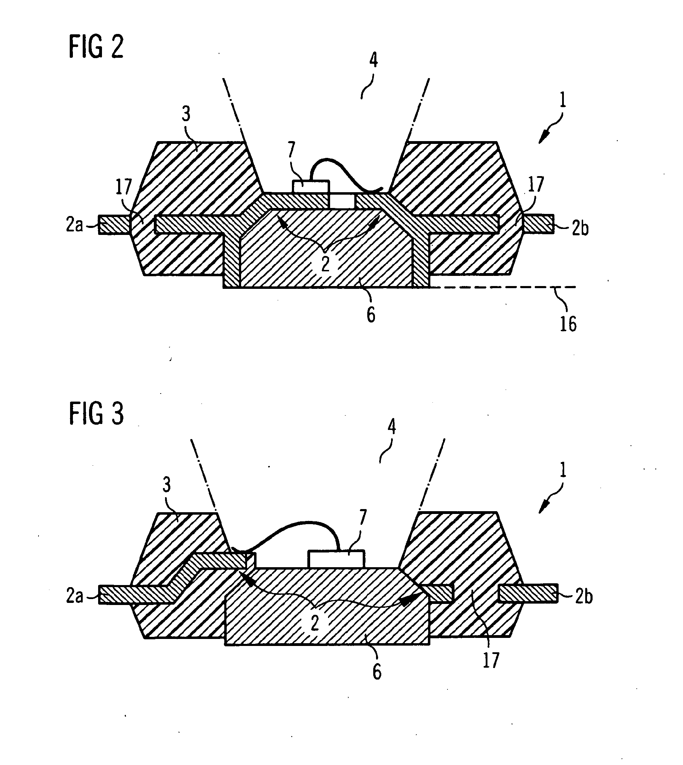

In Figur 2 ist eine schematische Schnittansicht eines ersten Ausführungsbeispiels eines strahlungsemittierenden Bauelements dargestellt. Das strahlungsemittierende Bauelement 1 weist einen pulverspritzgegossenen Gehäusekörper 3 auf, in dem ein pulverspritzgegossener Träger 2 mit zwei Anschlussbereichen 2a und 2b teilweise eingebettet ist. Die Anschlussbereiche 2a und 2b sind eben ausgebildet und verlaufen parallel zur Auflagefläche 16 des strahlungsemittierenden Bauelements 1. Die Anschlussbereiche 2a und 2b weisen Vertiefungen 17 auf, die mit dem Material, das der Gehäusekörper 3 enthält, gefüllt sind. Dadurch sind der Träger 2 und der Gehäusekörper 3 starr miteinander verbunden.

In den Träger 2 ist ein Kühlelement 6 eingelegt und zumindest umfangseitig mit dem Träger 2 verbunden. Bevorzugt sind der Träger 2 und das Kühlelement 6 einstückig ausgebildet. Das Kühlelement 6 kann ebenfalls durch Spritzguss beziehungsweise Pulverspritzguss hergestellt sein.

Des Weiteren kann das Kühlelement 6 mit dem Gehäusekörper 3 einstückig ausgebildet sein.

Das Kühlelement 6 enthält vorzugsweise ein thermisch leitendes oder wärmeabsorbierendes Material, beispielsweise ein Keramikmaterial, während der Träger 2 ein elektrisch leitendes Material, beispielsweise ein elementares Metall oder eine Metallverbindung, enthält. Der Träger 2 dient als Leiterrahmen, wodurch ein strahlungsemittierender Halbleiterkörper 7 elektrisch anschließbar ist. Gleichzeitig kann die im Betrieb erzeugte Wärme durch das Kühlelement 6 abgeführt werden.

Der Halbleiterkörper 7 ist auf den mit dem Anschlussbereich 2a verbundenen Teil des Trägers 2 montiert und mittels eines Bonddrahtes an den mit dem Anschlussbereich 2b verbundenen Teil des Trägers 2 angeschlossen. Der Halbleiterkörper 7 kann beispielsweise ein Leuchtdiodenchip, insbesondere ein Dünnfilm-Leuchtdiodenchip sein. Der Halbleiterkörper 7 ist in einer Ausnehmung 4 des Gehäusekörpers 3 angeordnet.

Die Ausnehmung 4 ist vorzugsweise als Reflektor ausgebildet. Dies kann durch eine auf die Innenwände des Gehäusekörpers 3, die an die Ausnehmung 4 grenzen, aufgebrachte Metallisierungsschicht realisiert sein, vorzugsweise jedoch durch Partikel, beispielsweise aus TiO₂, die in den Gehäusekörper 3 eingebracht sind und den Reflexionsgrad steigern.

In Figur 3 ist eine schematische Schnittansicht eines zweiten Ausführungsbeispiels eines strahlungsemittierenden Bauelements 1 dargestellt. Der Gehäusekörper 3 ist in dem der Auflagefläche 16 gegenüber liegenden oberen Bereich trichterartig ausgehöhlt. Am Boden der so gebildeten Ausnehmung 4 ist der strahlungsemittierende Halbleiterkörper 7 angeordnet. Dieser ist auf das Kühlelement 6 montiert, wobei die im Betrieb erzeugte Verlustwärme über das Kühlelement 6 abgeführt werden kann.

Die elektrische Versorgung des Halbleiterkörpers 7 erfolgt durch den zweiteilig ausgebildeten Träger 2, der zwei Anschlussbereiche 2a, 2b aufweist. Der Anschlussbereich 2a ragt dabei in die Ausnehmung 4 hinein, wo er freiliegt und mittels eines Drahtes mit dem Halbleiterkörper 7 verbunden ist. Der Anschlussbereich 2a ist von dem Kühlelement 6 durch den Gehäusekörper 3 elektrisch isoliert. Er verläuft annähernd S-förmig. Der Anschlussbereich 2b hingegen verläuft planar und ist mit dem Kühlelement 6 verbunden. Vorteilhafterweise sind der Anschlussbereich 2b und das Kühlelement 6 einstückig aus einem sowohl elektrisch als auch thermisch leitenden Material gebildet.

Der Anschlussbereich 2b weist die Vertiefung 17 auf, die mit dem Material des Gehäusekörpers 3 gefüllt ist. Dadurch und durch den S-förmigen Verlauf des Anschlussbereichs 2a kann die Verankerung des Gehäusekörpers 3 auf dem Träger 2 verbessert werden.

Die Innenwände des Gehäusekörpers 3 sind wie im ersten Ausführungsbeispiel als Reflektor ausgebildet.

Für die Herstellung eines strahlungsemittierenden Bauelements gemäß des zweiten Ausführungsbeispiels eignet sich wie für die Herstellung eines strahlungsemittierenden Bauelements gemäß des ersten Ausführungsbeispiels das Pulverspritzgussverfahren. Dabei können das Kühlelement 6 und der Anschlussbereich 2b einstückig ausgebildet werden. Der Anschlussbereich 2a kann separat hergestellt werden und gemeinsam mit dem Kühlelement 6 und dem Anschlussbereich 2b mit einer Formmasse für den Gehäusekörper 3 umspritzt werden.

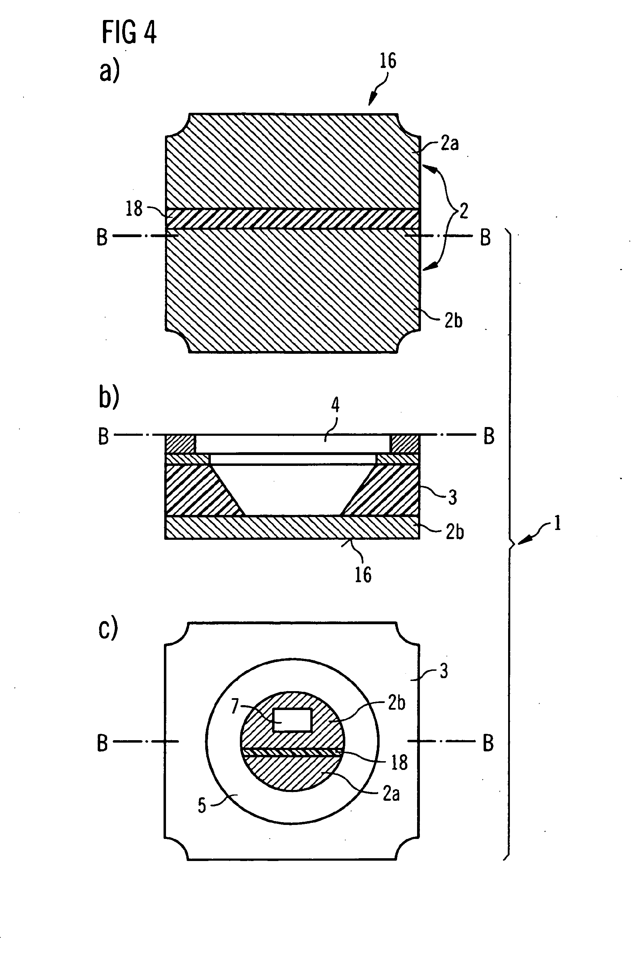

In den Figuren 4a, 4b, 4c sind drei verschiedene Ansichten eines dritten Ausführungsbeispiels eines strahlungsemittierenden Bauelements 1 schematisch dargestellt.

In Figur 4a ist die Auflagefläche 16 des strahlungsemittierenden Bauelements 1 schematisch dargestellt. Die Auflagefläche 16 ist in drei Bereiche unterteilt: den Anschlussbereich 2a, die Isolierschicht 18, und den Anschlussbereich 2b. Die Isolierschicht 18 wirkt zwischen den beiden Anschlussbereichen 2a, 2b elektrisch isolierend.

In Figur 4b ist ein Querschnitt des strahlungsemittierenden Bauelements 1 entlang der Linie B-B schematisch dargestellt. Der Anschlussbereich 2b bildet dabei eine untere Begrenzung des strahlungsemittierenden Bauelements 1. Dem Anschlussbereich 2b ist der Gehäusekörper 3 nachgeordnet. Der Gehäusekörper 3 weist eine Ausnehmung 4 auf, die vom Anschlussbereich 2b bis zu der der Auflagefläche 16 gegenüberliegenden Oberseite des strahlungsemittierenden Bauelements 1 reicht. Die Ausnehmung 4 weist eine topfartige Gestalt auf und ist in drei Bereiche gegliedert, die stufenförmig ineinander übergehen. Diese Abstufung erleichtert beispielsweise die Anbringung eines Deckels oder eines optischen Elements, vorzugsweise einer Linse. Ferner kann dadurch beispielsweise die Verankerung eines Vergusses erleichtert werden. Der obere Bereich, der durch einen Überlaufrahmen begrenzt wird, dient dann zur Aufnahme überschüssigen Vergussmaterials, mit dem der untere und der mittlere Bereich gefüllt sind. Durch eine Zurückversetzung des Überlaufrahmens gegenüber darunterliegenden Teilen des Gehäusekörpers 3 kann eine verbesserte Verankerung des Vergusses erzielt werden.

Innenwände des Gehäusekörpers 3, die an die Ausnehmung 4 grenzen, dienen vorzugsweise als Reflektor.

In Figur 4c ist eine Aufsicht auf das strahlungsemittierende Bauelement 1 schematisch dargestellt.

Die Innenwände des Gehäusekörpers 3 bilden einen Reflektor 5. Der Reflektor 5 ist in Richtung der Auflagefläche durch den Anschlussbereich 2a und den Anschlussbereich 2b begrenzt. Der Anschlussbereich 2a ist durch die Isolierschicht 18 von dem Anschlussbereich 2b elektrisch isoliert. Auf dem Anschlussbereich 2b ist der strahlungsemittierende Halbleiterkörper 7 montiert. Der Halbleiterkörper 7 kann mittels einer Drahtverbindung mit dem Anschlussbereich 2a verbunden sein.

Die Abstrahlcharakteristik der vom Halbleiterkörper 7 emittierten Strahlung kann durch den Reflektor 5 in geeigneter Weise beeinflusst werden. Vorzugsweise wird der Reflektor 5 durch die Ausnehmung 4 des Gehäusekörpers 3 gebildet und enthält ein Material, das mit Partikeln versetzt ist, die den Reflexionsgrad steigern. Dieses Material ist elektrisch isolierend, sodass der Gehäusekörper 3 direkt auf die Anschlussbereiche 2a, 2b aufgebracht sein kann, ohne dass dabei ein Kurzschluss verursacht wird.

Das strahlungsemittierende Bauelement 1 kann mittels zweier Pulverspritzgussverfahren einfach hergestellt werden. Die Anschlussbereiche 2a, 2b können mittels des Pulvermetallspritzgussverfahrens gefertigt werden. Der Gehäusekörper 3 kann mittels des Pulverspritzgussverfahrens hergestellt werden.

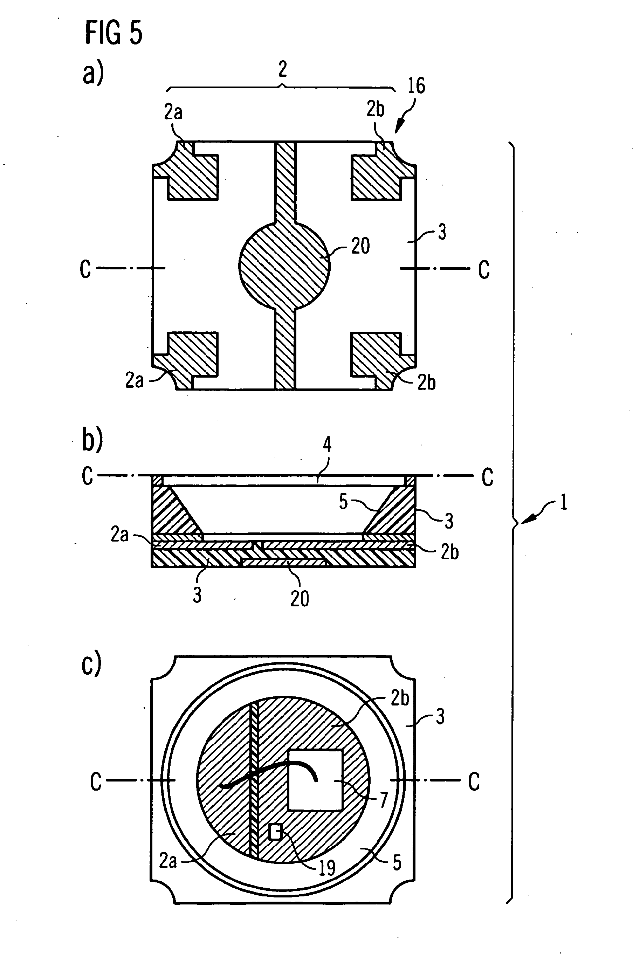

In den Figuren 5a, 5b, 5c sind drei verschiedene Ansichten eines vierten Ausführungsbeispiels eines erfindungsgemäßen strahlungsemittierenden Bauelements 1 dargestellt.

In Figur 5a ist die Auflagefläche 16 des strahlungsemittierenden Bauelements 1 schematisch dargestellt. In dem Gehäusekörper 3 sind der Anschlussbereich 2a und der Anschlussbereich 2b und der thermische Anschlussbereich 20, an den ein Kühlelement angeschlossen werden kann, zumindest teilweise eingebettet.

In Figur 5b ist ein Querschnitt des strahlungsemittierenden Bauelements 1 schematisch dargestellt. Das strahlungsemittierende Bauelement 1 weist auf der der Auflagefläche zugewandten Seite den thermischen Anschlussbereich 20 auf. Zweckmäßigerweise enthält der thermische Anschlussbereich 20 ein wärmeleitendes Material, beispielsweise ein Metall. Der thermische Anschlussbereich 20 ist in den Gehäusekörper 3 teilweise eingebettet, ebenso der Anschlussbereich 2a und der Anschlussbereich 2b, die als elektrische Anschlüsse verschiedener Polarität dienen können.

Der der Auflagefläche abgewandte Teil des Gehäusekörpers 3 weist die Ausnehmung 4 auf. Wie in Figur 4b sind die Innenwände des Gehäusekörpers 3 abgestuft, wobei lediglich die abgeschrägten Innenwände den Reflektor bilden. In diesem Ausführungsbeispiel ist dafür auf die Innenwände des Gehäusekörpers 3 teilweise eine Schicht, vorzugsweise eine Metallschicht, aufgebracht, wodurch der Reflexionsgrad gesteigert werden kann. Zwischen den Anschlussbereichen 2a und 2b und dem Reflektor 5 sind die Innenwände des Gehäusekörpers 3 nicht metallisiert, sodass keine Kurzschlussgefahr besteht. Die abgestufte Gestalt der Ausnehmung 4 begünstigt auch in diesem Ausführungsbeispiel die Aufbringung eines Deckels bzw. eines optischen Elements und/oder die Verankerung eines Vergusses.

In Figur 5c ist die Aufsicht auf das strahlungsemittierende Bauelement 1 schematisch gezeigt. Dargestellt ist der Gehäusekörper 3, in dessen Ausnehmung der strahlungsemittierende Halbleiterkörper 7 auf dem Anschlussbereich 2b angeordnet ist. Ferner ist ein ESD-Schutzchip 19 auf dem Anschlussbereich 2b montiert. Der Anschlussbereich 2a ist durch eine Unterbrechung von dem Anschlussbereich 2b elektrisch isoliert.

Die Abstrahlcharakteristik der vom Halbleiterkörper 7 emittierten Strahlung kann durch den Reflektor 5 so beeinflusst werden, dass das strahlungsemittierende Bauelement 1 eine hohe Leuchtdichte erzielt.

Wie in den vorhergehenden Ausführungsbeispielen beschrieben, lässt sich auch dieses Bauelement auf einfache Weise mittels zweier Pulverspritzgussverfahren herstellen.

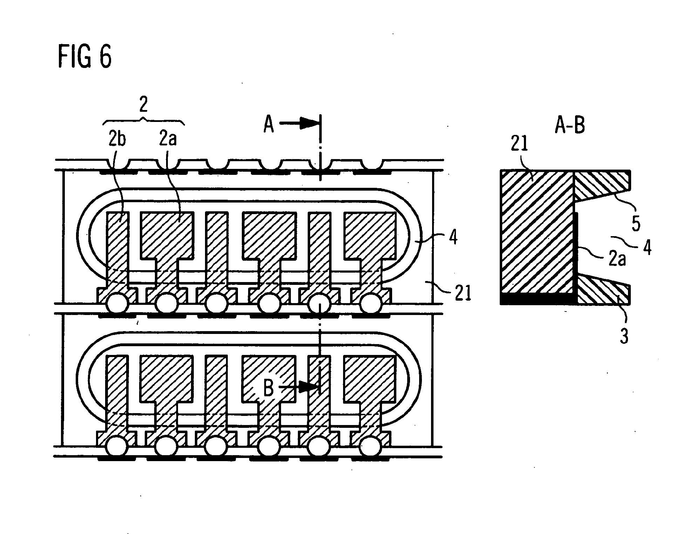

In Figur 6 ist eine schematische Aufsicht einer Anordnung von mehreren strahlungsemittierenden Halbleiterkörpern dargestellt. Die Halbleiterkörper sind in einer gemeinsamen Ausnehmung 4 mit einem ovalen Querschnitt angeordnet. Wie in der Schnittansicht A-B zu sehen ist, sind auf einem Grundkörper 21 zwei Anschlussbereiche 2a und 2b auf. Auf dem quadratischen Anschlussbereich 2a kann ein strahlungsemittierender Halbleiterkörper montiert sein, wobei der streifenförmige Anschlussbereich 2b zur oberseitigen Kontaktierung des Halbleiterkörpers dient.

Vorzugsweise werden die Anschlussbereiche 2a und 2b mittels des Pulvermetallspritzgussverfahrens gefertigt, während der Gehäusekörper 3 mittels des Pulverspritzgussverfahrens hergestellt wird. Der Grundkörper 21 kann ein Teil des Gehäusekörpers 3 sein.

Der Vorteil der in Figur 6 dargestellten Anordnung ist die Verwendung des Reflektors 5 für mehrere strahlungsemittierende Halbleiterkörper. Dies führt einerseits zu einer vereinfachten Herstellung. Andererseits kann dadurch die von den verschiedenen Halbleiterkörpern emittierte Strahlung gemischt werden. Dies kann z.B. bei der Erzeugung von Weißlicht gewünscht sein, wobei dann in der Anordnung Halbleiterkörper, die Strahlung unterschiedlicher Wellenlänge emittieren, verwendet werden.

Die Erfindung ist nicht durch die Beschreibung anhand der Ausführungsbeispiele beschränkt. Vielmehr umfasst die Erfindung jedes neue Merkmal sowie jede Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder Ausführungsbeispielen angegeben ist.

## Patentansprüche

1. Verfahren zur Herstellung eines strahlungsemittierenden Bauelements (1), das einen Gehäusekörper (3) und einen Träger (2) für einen darauf montierbaren strahlungsemittierenden Halbleiterkörper (7) aufweist, wobei
der Träger in einem Spritzgussverfahren aus einer Formmasse (34) hergestellt wird, die ein Metall enthält, und
der Gehäusekörper (3) in einem Spritzgussverfahren hergestellt wird, das die folgende Schritte aufweist:
- Herstellung einer Formmasse für den Gehäusekörper (3) aus einem Pulver, einem Binder, wobei ein fließfähiges Compound entsteht,
- Beigabe eines formgebenden Formbinders zur Formmasse,
- Einfüllung der Formmasse in eine Spritzgussform,
- Ausbildung eines Gehäusekörper-Formteils,
- Entfernung des Binders, wobei ein Gehäusekörper-Formteil entsteht,
- Sintern des Gehäusekörper-Formteils, wobei der Formbinder entfernt wird, und
- das Pulver für die Formmasse des Gehäusekörpers ein Kunststoffmaterial enthält.

2. Verfahren nach Anspruch 1, wobei
das Spritzgussverfahren für den Träger ein Pulverspritzgussverfahren ist.

3. Verfahren nach einem der vorhergehenden Ansprüche, das folgende Schritte zur Herstellung des Trägers aufweist:
- Herstellung einer Formmasse (34) aus einem Pulver (30), das ein Metall enthält, einem Binder und vorzugsweise einem oder mehreren Hilfsstoffen, wobei insbesondere bei Erwärmung oder Verdichtung der Formmasse (34) ein fließfähiges Compound entsteht,
- Beigabe eines formgebenden Formbinders zur Formmasse (34),
- Einfüllung der Formmasse (34) in eine Spritzgussform (36),
- Ausbildung eines Träger-Formteils (37),
- Entfernung des Binders,
- Sintern des Träger-Formteils (37), wobei der Formbinder entfernt wird.

4. Verfahren nach dem vorherigen Anspruch, wobei der Binder durch Erwärmung und/oder Lösungsmittel und/oder Pyrolyse entfernt wird.

5. Verfahren nach einem der obigen Ansprüche, wobei das Spritzgussverfahren für den Gehäusekörper (3) ein Pulverspritzgussverfahren ist.

6. Verfahren nach einem der obigen Ansprüche, wobei die Formmasse für den den Gehäusekörper (3) einen oder mehrere Hilfsstoffe aufweist,
- das fließfähige Compound bei Erwärmung oder Verdichtung der Formmasse entsteht, und
- der Binder durch Erwärmung und/oder Lösungsmittel und/oder Katalysation und/oder Pyrolyse entfernt wird.

7. Verfahren nach einem der Ansprüche 1 bis 6, wobei das Verfahren ein 2-Komponenten-Spritzgussverfahren ist.

8. Verfahren nach einem der Ansprüche 1 bis 7, wobei die Formmasse für den Träger (2) und die Formmasse für den Gehäusekörper (3) in verschiedene Spritzgussformen einer gemeinsamen Maschine eingefüllt werden.

9. Strahlungsemittierendes Bauelement (1), herstellbar gemäβ einem verfahren nach einem der Ansprüche 1 bis 8 das einen Gehäusekörper (1) und einen Träger (2), auf den ein strahlungsemittierender Halbleiterkörper montiert ist, aufweist, wobei der Träger ein spritzgegossenes Metall enthält und der Gehäusekörper (3) ein spritzgegossenes Kunststoffmaterial enthält.

10. Strahlungsemittierendes Bauelement (1) nach Anspruch 9, wobei
der Gehäusekörper (3) eine Ausnehmung (4) aufweist.

11. Strahlungsemittierendes Bauelement (1) nach Anspruch 10, wobei
der strahlungsemittierender Halbleiterkörper (7) in der Ausnehmung (4) angeordnet ist.

12. Strahlungsemittierendes Bauelement (1) nach Anspruch 11, wobei
der strahlungsemittierende Halbleiterkörper (7) ein Dünnfilm-Halbleiterkörper ist.

13. Strahlungsemittierendes Bauelement (1) nach Anspruch 12, wobei
der strahlungsemittierende Halbleiterkörper (7) von einer Umhüllung umgeben ist.

14. Strahlungsemittierendes Bauelement (1) nach Anspruch 13, wobei
die Umhüllung ein strahlungsdurchlässiges Material enthält.

15. Strahlungsemittierendes Bauelement (1) nach einem der Ansprüche 9 bis 14, wobei
die Umhüllung ein Konversionsmaterial enthält.

16. Strahlungsemittierendes Bauelement (1) nach einem der Ansprüche 9 bis 15, wobei
die Ausnehmung (4) als Reflektor (5) für die Strahlung dient, die von dem strahlungsemittierenden Halbleiterkörper (7) erzeugt wird.

17. Strahlungsemittierendes Bauelement (1) nach einem der Ansprüche 9 bis 16, wobei
der Gehäusekörper (3) Partikel mit reflektierender Wirkung enthält.

18. Strahlungsemittierendes Bauelement (1) nach Anspruch 17, wobei
der Gehäusekörper Partikel aus TiO₂ enthält.

19. Strahlungsemittierendes Bauelement (1) nach einem der Ansprüche 9 bis 18, wobei
der Gehäusekörper (3) ein UV-stabiles Material enthält.

20. Strahlungsemittierendes Bauelement (1) nach einem der Ansprüche 9 bis 19, wobei
der Träger (2) als Leiterrahmen dient.

21. Strahlungsemittierendes Bauelement (1) nach einem der Ansprüche 9 bis 20, wobei
auf dem Träger (2) eine kontaktierbare Metallisierung aufgebracht ist.

22. Strahlungsemittierendes Bauelement (1) nach einem der Ansprüche 9 bis 21, wobei
der Träger (2) Zusatzmaterialien zur Haftvermittlung enthält.

23. Strahlungsemittierendes Bauelement (1) nach einem der Ansprüche 9 bis 22, wobei
der Gehäusekörper (3) Zusatzmaterialien zur Haftvermittlung enthält.

24. Strahlungsemittierendes Bauelement (1) nach einem der Ansprüche 9 bis 23, wobei
das strahlungsemittierende Bauelement (1) gemäß eines Verfahrens nach einem der Ansprüche 1 bis 8 hergestellt wird.

## Claims

1. Method for producing a radiation-emitting component (1), which has a housing body (3) and a carrier (2) for a radiation-emitting semiconductor body (7) that can be mounted on it, wherein
the carrier is produced in an injection-moulding process from a moulding compound (34) which contains a metal, and the housing body (3) is produced in an injection-moulding process which comprises the following steps:
- producing a moulding compound for the housing body (3) from a powder and a binder, thereby creating a flowable compound,
- adding a shape-imparting moulding binder to the moulding compound,
- filling the moulding compound into an injection mould,
- forming a housing body moulding,
- removing the binder, thereby creating a housing body moulding, and
- sintering the housing body moulding, thereby removing the moulding binder,
the powder for the moulding compound of the housing body containing a plastics material.

2. Method according to Claim 1, wherein the injection-moulding process for the carrier is a powder injection-moulding process.

3. Method according to one of the preceding claims, which comprises the following steps for producing the carrier:
- producing a moulding compound (34) from a powder (30), which contains a metal, a binder and preferably one or more auxiliary agents, wherein a flowable compound is created in particular when the moulding compound (34) is heated or compacted,
- adding a shape-imparting moulding binder to the moulding compound (34),
- filling the moulding compound (34) into an injection mould (36),
- forming a carrier moulding (37),
- removing the binder,
- sintering the carrier moulding (37), while removing the moulding binder.

4. Method according to the preceding claim, wherein the binder is removed by heating and/or a solvent and/or pyrolysis.

5. Method according to one of the above claims, wherein the injection-moulding process for the housing body (3) is a powder injection-moulding process.

6. Method according to one of the above claims, wherein the moulding compound for the housing body (3) comprises one or more auxiliary agents,
- the flowable compound is created when the moulding compound is heated or compacted, and
- the binder is removed by heating and/or a solvent and/or catalysation and/or pyrolysis.

7. Method according to one of Claims 1 to 6, wherein the method is a 2-component injection-moulding process.

8. Method according to one of Claims 1 to 7, wherein the moulding compound for the carrier (2) and the moulding compound for the housing body (3) are filled into different injection moulds of a common machine.

9. Radiation-emitting component (1) that can be produced on the basis of a method according to one of Claims 1 to 8 and has a housing body (1) and a carrier (2), on which a radiation-emitting semiconductor body is mounted, wherein the carrier contains an injection-moulded metal and the housing body (3) contains an injection-moulded plastics material.

10. Radiation-emitting component (1) according to Claim 9, wherein the housing body (3) has a recess (4).

11. Radiation-emitting component (1) according to Claim 10, wherein the radiation-emitting semiconductor body (7) is arranged in the recess (4).

12. Radiation-emitting component (1) according to Claim 11, wherein the radiation-emitting semiconductor body (7) is a thin-film semiconductor body.

13. Radiation-emitting component (1) according to Claim 12, wherein the radiation-emitting semiconductor body (7) is surrounded by an encapsulation.

14. Radiation-emitting component (1) according to Claim 13, wherein the encapsulation contains a radiation-permeable material.

15. Radiation-emitting component (1) according to one of Claims 9 to 14, wherein the encapsulation contains a conversion material.

16. Radiation-emitting component (1) according to one of Claims 9 to 15, wherein the recess (4) serves as a reflector (5) for the radiation that is produced by the radiation-emitting semiconductor body (7).

17. Radiation-emitting component (1) according to one of Claims 9 to 16, wherein the housing body (3) contains particles with a reflective effect.

18. Radiation-emitting component (1) according to Claim 17, wherein the housing body contains particles of TiO₂.

19. Radiation-emitting component (1) according to one of Claims 9 to 18, wherein the housing body (3) contains a UV-stable material.

20. Radiation-emitting component (1) according to one of Claims 9 to 19, wherein the carrier (2) serves as a leadframe.

21. Radiation-emitting component (1) according to one of Claims 9 to 20, wherein a contactable metallization has been applied to the carrier (2).

22. Radiation-emitting component (1) according to one of Claims 9 to 21, wherein the carrier (2) contains additional materials for adhesion promotion.

23. Radiation-emitting component (1) according to one of Claims 9 to 22, wherein the housing body (3) contains additional materials for adhesion promotion.

24. Radiation-emitting component (1) according to one of Claims 9 to 23, wherein the radiation-emitting component (1) is produced on the basis of a method according to one of Claims 1 to 8.

## Revendications

1. Procédé de fabrication d'un composant (1) émettant un rayonnement,
le composant présentant un corps de boîtier (3) et un support (2) sur lequel un corps semi-conducteur (7) émettant un rayonnement peut être monté,
le support étant réalisé par une opération de moulage par injection d'une pâte de moulage (34) qui contient un métal et le corps de boîtier (3) étant réalisé dans une opération de moulage par injection qui présente les étapes suivantes :
préparation d'une pâte de moulage pour le corps de boîtier (3) à partir d'une poudre et d'un liant de manière à obtenir un mélange fluide,
addition d'un liant de moulage à la pâte de moulage,
introduction de la pâte de moulage dans un moule de moulage par injection,
formation d'une pièce moulée de corps de boîtier,
enlèvement du liant, ce qui fournit une pièce moulée de corps de boîtier, et
frittage de la pièce moulée du corps de boîtier, le liant de moulage étant enlevé,
la poudre prévue pour la pâte de moulage du corps de boîtier contenant une matière synthétique.

2. Procédé selon la revendication 1, dans lequel l'opération de moulage par injection du support est une opération de moulage de poudre par injection.

3. Procédé selon l'une des revendications précédentes, qui comprend les étapes suivantes pour la réalisation du support :
préparation d'une pâte de moulage (34) constituée d'une poudre (30) qui contient un métal, un liant et de préférence un ou plusieurs adjuvants de manière à obtenir un mélange fluide en particulier par chauffage de compression de la pâte de moulage (34),
addition d'un liant de moulage à la pâte de moulage (34),
introduction de la pâte de moulage (34) dans un moule (36) du moulage par injection,
formation d'une pièce moulée de support (37),
enlèvement du liant et
frittage de la pièce moulée de support (37) après avoir enlevé le liant.

4. Procédé selon la revendication précédente, dans lequel le liant est enlevé par chauffage, solvant et/ou pyrolyse.

5. Procédé selon l'une des revendications précédentes, dans lequel l'opération de moulage par injection du corps de boîtier (3) est une opération de moulage de poudre par injection.

6. Procédé selon l'une des revendications précédentes, dans lequel la pâte de moulage prévue pour le corps de boîtier (3) présente un ou plusieurs adjuvants, le composé fluide fournissant la pâte de moulage par chauffage ou compression et le liant étant enlevé par chauffage, solvant, catalyse et/ou pyrolyse.

7. Procédé selon l'une des revendications 1 à 6, dans lequel le procédé est un procédé de moulage par injection de deux composants.

8. Procédé selon l'une des revendications 1 à 7, dans lequel la pâte de moulage prévue pour le support (2) et la pâte de moulage prévue pour le corps de boîtier (3) sont introduites dans différents moules de moulage par injection d'une machine commune.

9. Composant (1) émettant un rayonnement, apte à être réalisé en recourant à un procédé selon l'une des revendications 1 à 8, et présentant un corps de boîtier (1) et un support (2) sur lequel est monté un corps semi-conducteur émettant un rayonnement, le support contenant un métal moulé par injection et le corps de boîtier (3) contenant une matière synthétique moulée par injection.

10. Composant (1) émettant un rayonnement selon la revendication 9, dans lequel le corps de boîtier (3) présente une découpe (4).

11. Composant (1) émettant un rayonnement selon la revendication 10, dans lequel le corps semi-conducteur (7) émettant un rayonnement est disposé dans la découpe (4).

12. Composant (1) émettant un rayonnement selon la revendication 11, dans lequel le corps semi-conducteur (7) émettant un rayonnement est un corps semi-conducteur en film mince.

13. Composant (1) émettant un rayonnement selon la revendication 12, dans lequel le corps semi-conducteur (7) émettant un rayonnement est entouré par une enveloppe.

14. Composant (1) émettant un rayonnement selon la revendication 13, dans lequel l'enveloppe contient un matériau transparent au rayonnement.

15. Composant (1) émettant un rayonnement selon l'une des revendications 9 à 14, dans lequel l'enveloppe contient un matériau de conversion.

16. Composant (1) émettant un rayonnement selon l'une des revendications 9 à 15, dans lequel la découpe (4) sert de réflecteur (6) au rayonnement émis par le corps semi-conducteur (7) émettant un rayonnement.

17. Composant (1) émettant un rayonnement selon l'une des revendications 9 à 16, dans lequel le corps de boîtier (3) contient des particules à effet réfléchissant.

18. Composant (1) émettant un rayonnement selon la revendication 17, dans lequel le corps de boîtier contient des particules de TiO₂.

19. Composant (1) émettant un rayonnement selon l'une des revendications 9 à 18, dans lequel le corps de boîtier (3) contient un matériau stable vis-à-vis des UV.

20. Composant (1) émettant un rayonnement selon l'une des revendications 9 à 19, dans lequel le support (2) sert de cadre conducteur.

21. Composant (1) émettant un rayonnement selon l'une des revendications 9 à 20, dans lequel une métallisation apte à assurer un contact est appliquée sur le support (2).

22. Composant (1) émettant un rayonnement selon l'une des revendications 9 à 21, dans lequel le support (2) contient des matériaux supplémentaires de renforcement de l'adhérence.

23. Composant (1) émettant un rayonnement selon l'une des revendications 9 à 22, dans lequel le corps de boîtier (3) contient des matériaux supplémentaires de renforcement de l'adhérence.

24. Composant (1) émettant un rayonnement selon l'une des revendications 9 à 23, dans lequel le composant (1) émettant un rayonnement est réalisé par recours à un procédé selon l'une des revendications 1 à 8.
